# EUROPEAN PATENT APPLICATION

(11) **EP 4 626 142 A1**
(43) Date of publication of application: **01.10.2025**
(21) Application number: 23893629.8
(22) Date of filing: 07.11.2023
(51) Int. Cl.: H05K 1/02, H05K 1/11, H05K 1/14

(54) **PRINTED CIRCUIT BOARD ASSEMBLY, CENTRAL COMPUTER MODULE, AND VEHICLE**

(30) Priority: 25.11.2022 CN 202223153322 U
(71) Applicant: Nio Technology (Anhui) Co., Ltd, Hefei City, Anhui 230601 (CN)
(72) Inventor: LU, Ming, Shanghai 201804 (CN); GAO, Xianglong, Shanghai 201804 (CN); LIU, Shuaijie, Shanghai 201804 (CN)
(74) Representative: Vossius & Partner Patentanwälte Rechtsanwälte mbB
(86) International application number: PCT/CN2023/130280
(87) International publication number: WO 2024/109538

(57) **Abstract**

The invention relates to the technical field of vehicles, and particularly provides a printed circuit board assembly, a central computer module and a vehicle, aiming to solve the technical problem that due to unreasonable layout of various lines on existing printed circuit board assemblies, signal transmission lines are susceptible to electromagnetic interference caused by switching power supplies, which directly affects the transmission speed and integrity of the signal. Therefore, the printed circuit board assembly of the invention comprises a board body, and a plurality of control chips, a plurality of memory chips, a plurality of groups of switching power supplies and signal transmission lines for data transmission that are mounted on the board body, wherein the control chips, the memory chips, and the signal transmission lines are all distributed in a signal transmission area of the board body, and the switching power supplies are distributed in a power transmission area of the board body. With such a configuration, the signal transmission lines and the switching power supplies are arranged in separate areas, and no intersection is generated between the signal transmission lines and the switching power supplies, thereby weakening the electromagnetic interference on the signal transmission lines caused by the switching power supplies, and ensuring the transmission speed and integrity of the signal.

## Description

The invention claims the priority to Chinese Patent Application No. CN202223153322.9, filed on November 25, 2022, and entitled "PRINTED CIRCUIT BOARD ASSEMBLY, CENTRAL COMPUTER MODULE, AND VEHICLE", which is incorporated herein by reference in its entirety.

### Technical Field

The invention relates to the technical field of vehicles, and particularly provides a printed circuit board assembly, a central computer module and a vehicle.

### Background Art

In recent years, with the rapid development and application of artificial intelligence and big data, automotive technology has continued to advance towards automation and intelligence, and these advances are inseparable from the acquisition of a more powerful computing capability for in-vehicle printed circuit board assemblies. In order to further improve the data processing capability, the method of integrating more intelligent chips on a printed circuit board assembly is adopted to achieve the desired effect.

However, as the number of smart chips and various connection lines on the printed circuit board assembly continues to increase, and due to the unreasonable layout of the lines, various lines are densely intertwined, making signal transmission lines susceptible to electromagnetic interference caused by switching power supplies, which directly affects the transmission speed and integrity of the signal.

Therefore, there is a need for a new technical solution in the art to solve the problems described above.

### Summary

The invention is intended to solve the above technical problem, i.e., to solve the technical problem that due to unreasonable layout of various lines on existing printed circuit board assemblies, the lines are densely intertwined, making signal transmission lines susceptible to electromagnetic interference caused by switching power supplies, which directly affects the transmission speed and integrity of the signal.

In a first aspect, the invention provides a printed circuit board assembly, which comprises a board body, and a plurality of control chips, a plurality of memory chips and a plurality of groups of switching power supplies that are mounted on the board body, the control chips being connected to each other by signal transmission lines, the control chips and the memory chips being connected by signal transmission lines, and the switching power supplies being connected to an external power supply and the control chips to transmit power to the control chips, and is characterized in that the board body comprises a signal transmission area and a power transmission area that are separated from each other, the control chips, the memory chips and the signal transmission lines are all located in the signal transmission area, and the switching power supplies are located in the power transmission area.

With such a configuration, the signal transmission lines and the switching power supplies can be isolated in different areas and no intersection is generated between the signal transmission lines and the switching power supplies, thereby weakening the electromagnetic interference on the signal transmission lines caused by the switching power supplies, and effectively ensuring the transmission speed and integrity of the signal.

In a preferred technical solution of the printed circuit board assembly described above, the signal transmission area is in the middle of the board body, and the power transmission area is on the periphery of the signal transmission area.

With such a configuration, the switching power supplies and the signal transmission lines can be separated in different areas, avoiding the electromagnetic interference caused by the spatial intersection of the switching power supplies and the signal transmission lines, and moreover, a sufficiently large space can be provided for the arrangement of more switching power supplies to ensure sufficient power transmission.

In a preferred technical solution of the printed circuit board assembly described above, the power transmission area comprises a first power transmission area and a second power transmission area that are separated by the signal transmission area in a length direction of the board body, the first power transmission area and the second power transmission area are provided on two sides of the signal transmission area in the length direction of the board body, the plurality of groups of switching power supplies are uniformly distributed in the first power transmission area and the second power transmission area, the switching power supplies located in the first power transmission area are electrically connected to the control chips near the first power transmission area, and the switching power supplies located in the second power transmission area are electrically connected to the control chips near the second power transmission area.

With such a configuration, on the one hand, the two power transmission areas are provided on the two sides of the signal transmission area, so that the switching power supplies in each power transmission area can be connected to control chips adjacent thereto and transmit power, avoiding the electromagnetic interference caused by the intersection of the switching power supplies entering the signal transmission area and the signal transmission lines; on the other hand, the wiring length is reduced and the transmission distance is shortened; and furthermore, by evenly distributing the switching power supplies in the first power transmission area and the second power transmission area, the same power transmission capacity on both sides can be ensured, making the power transmitted to the respective control chips more balanced and stable.

In a preferred technical solution of the printed circuit board assembly described above, the signal transmission area comprises a transmission line area in the middle of the signal transmission area, first signal transmission lines between the control chips are all located in the transmission line area, and the switching power supplies are electrically connected to the control chips bypassing the transmission line area.

With such a configuration, the first signal transmission lines for transmitting data between the control chips are completely in a center region of the board body, and are completely isolated from other electromagnetic interference sources, thus ensuring their normal data transmission.

In a preferred technical solution of the printed circuit board assembly described above, the signal transmission area further comprises a first signal transmission area and a second signal transmission area on two sides of the transmission line area in a width direction of the board body, the plurality of control chips and the memory chips corresponding thereto are uniformly distributed in the first signal transmission area and the second signal transmission area, and at least one of the memory chips corresponding to each of the control chips is uniformly distributed on the side of the control chip that is away from the transmission line area, and second signal transmission lines between the control chips and the memory chips are located in the first signal transmission area and the second signal transmission area.

With such a configuration, the second signal transmission lines used for data transmission between the control chips and the memory chips are partitioned from the first signal transmission lines, avoiding spatial intersection of the first signal transmission lines and the second signal transmission lines, thus minimizing the electromagnetic interference on the first signal transmission lines from the second signal transmission lines.

In a preferred technical solution of the printed circuit board assembly described above, the control chips on the side of the first signal transmission area are in staggered arrangement with the control chips on the side of the second signal transmission area.

With such a configuration, each of the control chips is at a gap between any two control chips on the other side, helping to quickly dissipate heat generated during the operation of the control chips through the gap, and avoiding excessive heat accumulation on the printed circuit board assembly, which may cause a quick temperature rise of the control chips and then directly affect their data processing speed and stability.

In a preferred technical solution of the printed circuit board assembly described above, the first signal transmission area and the second signal transmission area are each provided with two control chips, the two control chips are uniformly distributed in the length direction of the board body, each of the control chips corresponds to four memory chips, and each of the control chips is electrically connected to the corresponding switching power supply.

With such a configuration, on the one hand, the data processing capability of the printed circuit board assembly is enhanced by computation superposition of the plurality of control chips, and on the other hand, the layout of the respective chips and switching power supplies is optimized, and spatial isolation of the transmission line area, the first signal transmission area, the second signal transmission area, and the power transmission area is realized, thus minimizing the electromagnetic interference on the first signal transmission lines.

In a preferred technical solution of the printed circuit board assembly described above, the plurality of groups of switching power supplies are distributed on the front and back sides of the power transmission area.

With such a configuration, the limited space on the front and back sides of the board body is fully utilized to accommodate more switching power supplies, thus improving the space utilization rate of the board body while facilitating the control of the overall size of the board body.

In a second aspect, the invention further provides a central computer module comprising a printed circuit board assembly described above, and thereby having the technical effects possessed by the printed circuit board assembly described above. As compared with the central computer module before the improvement, the central computer module of the invention has a better heat dissipation performance and obtains a greater data processing capability.

In a third aspect, the invention further provides a vehicle comprising a central computer module described above, and thereby having the technical effects possessed by the central computer module described above. As compared with the vehicle before improvement, the vehicle of the invention has smoother operation of functions, comprehensively improving the driving experience and safety of the passengers.

### Brief Description of the Drawings

Preferred implementations of the invention are described below with reference to the accompanying drawings, in which:
FIG. 1 is a schematic diagram I of a front structure of a printed circuit board assembly of the invention;
FIG. 2 is a schematic diagram II of a front structure of a printed circuit board assembly of the invention; and
FIG. 3 is a schematic diagram of a rear structure of a printed circuit board assembly of the invention.

### List of reference signs:

1. board body; 11. first power transmission area; 12. second power transmission area; 13. first signal transmission area; 14. second signal transmission area; 15. transmission line area; 2. control chip; 3. memory chip; 4. switching power supply; 51. first signal transmission line; 52. second signal transmission line.

### Detailed Description of Embodiments

Preferred implementations of the invention will be described below with reference to the accompanying drawings. Those skilled in the art should understand that these implementations are merely used to explain the technical principles of the invention, and are not intended to limit the scope of protection of the invention.

It should be noted that, in the description of the invention, the terms that indicate the directions or positional relationships, such as "upper", "lower", "top" and "bottom", are based on the directions or positional relationships shown in the accompanying drawings, are merely for ease of description instead of indicating or implying that the device or element must have a particular orientation and be constructed and operated in a particular orientation, and therefore, should not be construed as limiting the invention. In addition, the terms "first" and "second" are used for descriptive purposes only, and cannot be construed as indicating or implying relative importance.

In addition, it should also be noted that, in the description of the invention, the terms "dispose", "connect" and "mount" should be interpreted in a broad sense unless explicitly defined and limited otherwise. For example, a connection may be a fastened connection, a detachable connection, or an integral connection. For those skilled in the art, the specific meanings of the foregoing terms in the invention can be interpreted according to a specific situation.

Based on the background art, it points out the technical problem that due to the unreasonable layout of various lines on existing printed circuit board assemblies, signal transmission lines are susceptible to electromagnetic interference caused by switching power supplies, which directly affects the transmission speed and integrity of the signal. To this end, the invention provides a vehicle and a printed circuit board assembly for the vehicle, and is intended to realize that the signal transmission lines and the switching power supplies are arranged in separate areas and no intersection is generated between the signal transmission lines and the switching power supplies, thereby weakening the electromagnetic interference on the signal transmission lines caused by the switching power supplies, and effectively ensuring the transmission speed and integrity of the signal.

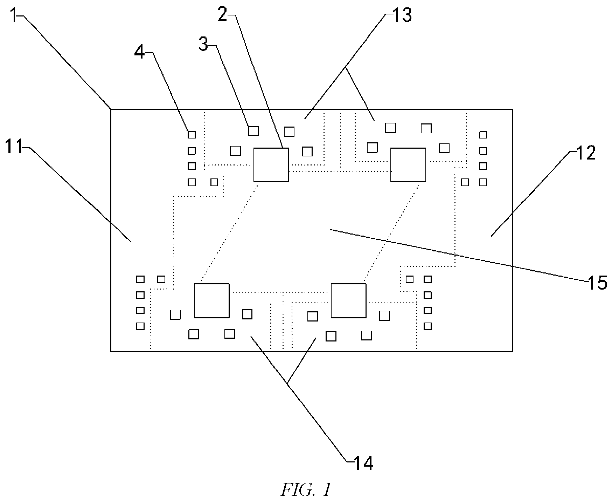

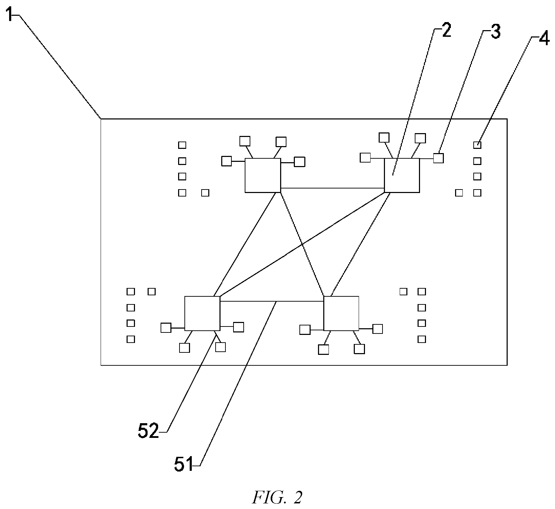

Specifically, as shown in FIGS. 1 and 2, the printed circuit board assembly of the invention comprises a board body 1, and a plurality of control chips 2, a plurality of memory chips 3 and a plurality of switching power supplies 4 that are mounted on the board body 1. The control chips 2 are connected to each other by signal transmission lines, and the control chips 2 and the memory chips 3 are connected by signal transmission lines. The switching power supplies 4 are connected to an external power supply and the control chips 2 to transmit power to the control chips 2. The board body 1 comprises a signal transmission area and a power transmission area that are separated from each other, where the control chips 2, the memory chips 3, and the signal transmission lines are all located in the signal transmission area, and the switching power supplies 4 are located in the power transmission area.

As the switching power supplies 4 and the signal transmission lines are capable of generating electromagnetic radiation, the signal transmission lines are susceptible to the electromagnetic interference caused by the switching power supplies 4 or other signal transmission lines, which affects their normal signal transmission. The switching power supplies 4 are the most important interference source for the signal transmission lines. Especially when the signal transmission lines and the switching power supplies 4 or other signal transmission lines are laid closely or cross each other, the intensity of the electromagnetic radiation on the signal transmission lines increases exponentially, and therefore, during layout of the signal transmission lines, it is necessary to isolate them from the interference source or keep them away from the interference source as much as possible so as to reduce the electromagnetic interference on the signal transmission lines.

In the invention, the board body 1 is divided into the signal transmission area and the power transmission area, and the signal transmission area and the power transmission area have no spatial intersection, so that the signal transmission lines are all laid in the signal transmission area, and the switching power supplies 4 are all laid in the power transmission area. In this way, the signal transmission lines and the switching power supplies 4 are completely separated in different areas, and traces of the two do not cross and are spaced apart by a certain distance, thus greatly weakening the electromagnetic interference on the signal transmission lines caused by the switching power supplies 4, and effectively ensuring the transmission speed and integrity of the signal.

Preferably, as shown in FIGS. 1 and 2, the signal transmission area of the invention is in the middle of the board body 1, and the power transmission area is on the periphery of the signal transmission area.

Exemplarily, the signal transmission area is in the middle of the board body 1, and the power transmission area is on the periphery of the signal transmission area and at the edge of the board body 1. In this way, in the process of the external power supply transmitting power to the control chips 2, the switching power supplies 4 for power transmission only need to pass through the power transmission area on the periphery, and does not need to enter the signal transmission area in the middle of the board body 1, thus avoiding the crossing between the signal transmission lines and the switching power supplies 4, reducing the interference on the signal transmission lines caused by electromagnetic radiation generated by the switching power supplies 4, and ensuring stable signal transmission.

In addition, as the demand for high current from a multi-chip system increases, the number of switching power supplies 4 needs to be increased accordingly, which requires the power transmission area to have enough space to accommodate more switching power supplies 4. Therefore, disposing the power transmission area on the periphery of the signal transmission area can provide a sufficiently large space for the arrangement of the plurality of groups of switching power supplies 4.

It should be noted that, in practical applications, those skilled in the art may also divide the board body 1 from the middle, with half of the area of the board body 1 being designated as the signal transmission area, and the other half of the area of the board body 1 being designated as the power transmission area; and the control chips 2 and the switching power supplies 4 are arranged, in an extension direction of a middle boundary, on two sides of the boundary, and the switching power supplies 4 are electrically connected to the control chips 2 adjacent thereto to realize power transmission, as long as the signal transmission area and the power transmission area have no intersection. This flexible adjustment and change does not depart from the scope of the invention, and shall be limited to the scope of the invention.

The invention preferably adopts a solution in which the signal transmission area is provided in the middle of the board body 1 and the power transmission area is provided on the periphery.

Preferably, as shown in FIGS. 1 and 2, the power transmission area in the invention comprises a first power transmission area 11 and a second power transmission area 12 that are separated by the signal transmission area in a length direction of the board body 1, the first power transmission area 11 and the second power transmission area 12 are provided on two sides of the signal transmission area in a length direction of the board body 1, the plurality of groups of switching power supplies 4 are uniformly distributed in the first power transmission area 11 and the second power transmission area 12, the switching power supplies 4 located in the first power transmission area 11 are electrically connected to the control chips 2 near the first power transmission area 11, and the switching power supplies 4 located in the second power transmission area 12 are electrically connected to the control chips 2 near the second power transmission area 12.

Specifically, the power transmission area is divided into the first power transmission area 11 and the second power transmission area 12, and the first power transmission area 11 and the second power transmission area 12 are respectively provided on the two sides of the signal transmission area, thus forming the layout in which the first power transmission area 11, the signal transmission area, and the second power transmission area 12 are sequentially arranged in the length direction of the board body 1. Moreover, the plurality of control chips 2 are uniformly distributed at positions in the signal transmission area near the first power transmission area 11 and the second power transmission area 12, and the switching power supplies 4 located in the two power transmission areas are connected to the control chips 2 adjacent thereto, respectively, which not only avoids the electromagnetic interference caused by the intersection between the switching power supplies 4 and the signal transmission lines in the signal transmission area, but also reduces the wiring length of the switching power supplies 4, thus shortening the power transmission distance, and improving the power transmission efficiency.

Preferably, as shown in FIGS. 1 and 2, the signal transmission area of the invention comprises a transmission line area 15 in the middle of the signal transmission area, first signal transmission lines 51 between the control chips 2 are all located in the transmission line area 15, and the switching power supplies 4 are electrically connected to the control chips 2 bypassing the transmission line area 15.

Since the first signal transmission lines 51 are used for data transmission between the control chips 2, the electromagnetic interference from the interference source here needs to be minimized. Therefore, the first signal transmission lines 51 are completely disposed in a center region of the board body 1, and are completely isolated from other electromagnetic interference sources, thus ensuring their normal data transmission.

Preferably, as shown in FIGS. 1 and 2, the signal transmission area of the invention further comprises a first signal transmission area 13 and a second signal transmission area 14 on two sides of the transmission line area 15 in a width direction of the board body 1, the plurality of control chips 2 and the memory chips 3 corresponding thereto are uniformly distributed in the first signal transmission area 13 and the second signal transmission area 14, at least one of the memory chips 3 corresponding to each of the control chips 2 is uniformly distributed on the side of the control chip 2 that is away from the transmission line area 15, and second signal transmission lines 52 between the control chips 2 and the memory chips 3 are located in the first signal transmission area 13 and the second signal transmission area 14.

Since electromagnetic interference of a certain intensity may be generated between the signal transmission lines, for example, in the invention, mutual interference may be generated between the second signal transmission lines 52 for connecting the control chips 2 to the memory chips 3 and the first signal transmission lines 51, the electromagnetic interference caused by the second signal transmission lines 52 should also be taken into account during the layout of the printed circuit board assembly.

Specifically, in the printed circuit board assembly of the invention, the signal transmission area is divided into the transmission line area 15 and the first signal transmission area 13 and the second signal transmission area 14 on the two sides of the transmission line area 15, with the first signal transmission area 13, the transmission line area 15, and the second signal transmission area 14 being arranged sequentially in the width direction of the board body 1. The first signal transmission lines 51 are all laid within the transmission line area 15, and the second signal transmission lines 52 are all laid in the first signal transmission area 13 and the second signal transmission area 14. Because the memory chips 3 are all arranged on the outer side of the control chips 2, the second signal transmission lines 52 connecting the control chips 2 to the memory chips 3 are all located on the outer side of the control chips 2, and the first signal transmission lines 51 connecting the various control chips 2 are all located on the inner side of the control chips 2, thus avoiding spatial intersection between the first signal transmission lines 51 and the second signal transmission lines 52, and minimizing the electromagnetic interference on the first signal transmission lines 51 from the second signal transmission lines 52.

Preferably, as shown in FIGS. 1 and 2, in the invention, the control chips 2 on the side of the first signal transmission area 13 are in staggered arrangement with the control chips 2 on the side of the second signal transmission area 14.

The chips generate heat during operation, resulting in a quick temperature rise of the chips, and the temperature rise directly affects the computing capability and stability of the chips. Therefore, the control chips 2 on two sides are in staggered arrangement and each of the control chips 2 is at a gap between any two control chips 2 on the other side, thus helping to quickly dissipate the heat generated during the operation of the control chips 2 through the gap, and avoiding excessive heat accumulation on the printed circuit board assembly, which may cause the quick temperature rise of the control chips 2 and then affect their data processing speed and stability.

Exemplarily, the printed circuit board assembly is usually mounted on a vertical plane in a vehicle, here, the first signal transmission area 13 is above the second signal transmission area 14, and the heat generated by the control chips 2 on the side of the second signal transmission area 14 on the lower side will quickly move to the higher side (the side of the first signal transmission area 13). Therefore, only by staggering the upper and lower control chips 2, the heat generated by the control chips 2 on the lower side can be quickly dissipated through the gap between the two adjacent control chips 2 on the upper side, which effectively enhances the heat dissipation performance of the printed circuit board assembly and improves its computing speed and stability.

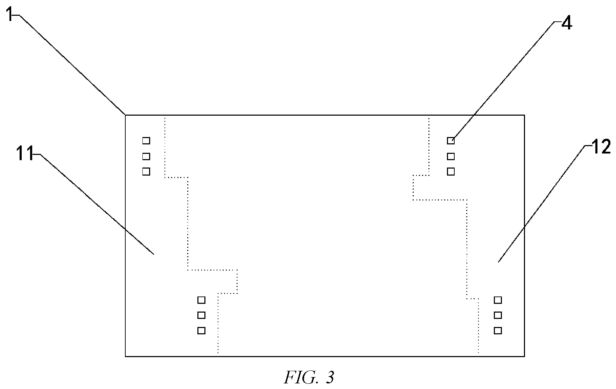

Preferably, as shown in FIGS. 1 and 3, the first signal transmission area 13 and the second signal transmission area 14 in the invention are each provided with two control chips 2, the two control chips 2 are uniformly distributed in the length direction of the board body 1, each of the control chips 2 corresponds to four memory chips 3, and each of the control chips 2 is electrically connected to the corresponding switching power supply 4.

Exemplarily, in each of the first signal transmission area 13 and the second signal transmission area 14, two control chips 2 are mounted in the length direction of the board body 1 near the transmission line area 15, four memory chips 3 are mounted on the side of each control chip 2 that is away from the transmission line area 15, and the four memory chips 3 are arranged along a semicircular arc with the corresponding control chip 2 as the center, and moreover, each of the four memory chips 3 is electrically connected to the corresponding control chip 2 by the second signal transmission line 52 so as to realize signal transmission and data interaction between the control chip 2 and the memory chip 3.

With respect to the single-chip architecture of the conventional printed circuit board assembly, the printed circuit board assembly of the invention obtains sufficiently strong computing capability through computation superposition of the four control chips 2, and the layout of the printed circuit board assembly is also optimized. That is, by connecting the switching power supplies 4 at the edge of the board body 1 to the control chips 2 adjacent thereto, the electromagnetic interference caused by intersection between the switching power supplies 4 and the signal transmission lines is avoided, thus minimizing the electromagnetic interference on the signal transmission lines.

In addition, each of the control chips 2 is connected to the same number of switching power supplies 4, and the number of switching power supplies 4 corresponding to each of the control chips 2 in the invention is preferably eight, so that in addition to meeting the demand for high current of each of the control chips 2, it can also ensure that each of the control chips 2 receives the same power transmission, the current flowing in each of the control chips 2 on the printed circuit board assembly is more balanced, and the operation stability of the printed circuit board assembly is ensured.

Preferably, as shown in FIGS. 1 and 3, the plurality of groups of switching power supplies 4 of the invention are distributed on the front and back sides of the power transmission area.

Due to the increase in the number of control chips 2, the demand for current intensity will also increase, resulting in an increase in the number of switching power supplies 4. However, due to the limitation of mounting space as well as considerations on cost control, the dimension of the printed circuit board assembly is required to be limited to a small range. Therefore, it is necessary to make full use of the space on the two sides of the board body 1, and rationally distribute the plurality of groups of switching power supplies 4 on the front and back sides of the power transmission area, thus improving the space utilization rate of the board body 1.

It should be noted that the number of the plurality of groups of switching power supplies 4 to be arranged on the front and back sides of the board body 1 respectively may be allocated arbitrarily according to needs, and preferably in the invention, 20 groups are arranged on the front side of the board body and 12 groups are arranged on the back side of the board body 1.

In addition, the invention provides a central computer module comprising a printed circuit board assembly described above

Finally, the invention further provides a vehicle comprising a central computer described above.

Heretofore, the technical solutions of the invention have been described with reference to the preferred implementations shown in the accompanying drawings. However, those skilled in the art can readily understand that the scope of protection of the invention is apparently not limited to these specific implementations. Without departing from the principles of the invention, those skilled in the art may make equivalent changes or replacements to related technical features. The technical solutions obtained after these changes or replacements fall within the scope of protection of the invention.

## Claims

1. A printed circuit board assembly, which comprises a board body, and a plurality of control chips, a plurality of memory chips and a plurality of groups of switching power supplies that are mounted on the board body, the control chips being connected to each other by signal transmission lines, the control chips and the memory chips being connected by signal transmission lines, and the switching power supplies being connected to an external power supply and the control chips to transmit power to the control chips, and is **characterized in that** the board body comprises a signal transmission area and a power transmission area that are separated from each other, the control chips, the memory chips and the signal transmission lines are all located in the signal transmission area, and the switching power supplies are located in the power transmission area.

2. The printed circuit board assembly according to claim 1, **characterized in that** the signal transmission area is in the middle of the board body, and the power transmission area is on the periphery of the signal transmission area.

3. The printed circuit board assembly according to claim 2, **characterized in that** the power transmission area comprises a first power transmission area and a second power transmission area that are separated by the signal transmission area in a length direction of the board body, the first power transmission area and the second power transmission area are provided on two sides of the signal transmission area in the length direction of the board body, the plurality of groups of switching power supplies are uniformly distributed in the first power transmission area and the second power transmission area, the switching power supplies located in the first power transmission area are electrically connected to the control chips near the first power transmission area, and the switching power supplies located in the second power transmission area are electrically connected to the control chips near the second power transmission area.

4. The printed circuit board assembly according to claim 2, **characterized in that** the signal transmission area comprises a transmission line area in the middle of the signal transmission area, first signal transmission lines between the control chips are all located in the transmission line area, and the switching power supplies are electrically connected to the control chips bypassing the transmission line area.

5. The printed circuit board assembly according to claim 4, **characterized in that** the signal transmission area further comprises a first signal transmission area and a second signal transmission area on two sides of the transmission line area in a width direction of the board body, the plurality of control chips and the memory chips corresponding thereto are uniformly distributed in the first signal transmission area and the second signal transmission area, at least one of the memory chips corresponding to each of the control chips is uniformly distributed on the side of the control chip that is away from the transmission line area, and second signal transmission lines between the control chips and the memory chips are located in the first signal transmission area and the second signal transmission area.

6. The printed circuit board assembly according to claim 5, **characterized in that** the control chips on the side of the first signal transmission area are in staggered arrangement with the control chips on the side of the second signal transmission area.

7. The printed circuit board assembly according to claim 5, **characterized in that** the first signal transmission area and the second signal transmission area are each provided with two control chips, the two control chips are uniformly distributed in the length direction of the board body, each of the control chips corresponds to four memory chips, and each of the control chips is electrically connected to the corresponding switching power supply.

8. The printed circuit board assembly according to any one of claims 1 to 7, **characterized in that** the plurality of groups of switching power supplies are distributed on the front and back sides of the power transmission area.

9. A central computer module, **characterized in that** the central computer module comprises a printed circuit board assembly according to any one of claims 1 to 8.

10. A vehicle, **characterized in that** the vehicle comprises a central computer module according to claim 9.
